# EUROPEAN PATENT APPLICATION

(11) **EP 1 396 836 A1**
(43) Date of publication of application: **10.03.2004**
(21) Application number: 02736030.4
(22) Date of filing: 07.06.2002
(51) Int. Cl.: G09F 9/40, G09F 9/30, H05B 33/12, H05B 33/10, H05B 33/14

(54) **TIE-RING TYPE DISPLAY DEVICE, AND METHOD OF MANUFACTURING THE DISPLAY DEVICE**

(30) Priority: 13.06.2001 JP 2001179148
(71) Applicant: Sony Corporation, Tokyo 141-0001 (JP)
(72) Inventor: CHIBA, Yasuhiro, c/o SONY CORPORATION, Tokyo 141-0001 (JP); URABE, Tetsuo, c/o SONY CORPORATION, Tokyo 141-0001 (JP)
(74) Representative: Müller, Frithjof E., Dipl.-Ing.
(86) International application number: PCT/JP2002/005698
(87) International publication number: WO 2002/103663

(57) **Abstract**

A high-quality tiled display system and a method for manufacturing the same are provided, wherein the tiled display system includes organic EL display panels having improved high contrast by using a black matrix and has inconspicuous boundaries. A UV-curing resin (62) is applied onto principal surfaces of tiled display panels (60), and a sealing substrate (66) is then placed onto a surface having the resin thereon. In this operation, it must be avoided that there are bubbles between the UV-curing resin (62) and the sealing substrate (66). The position of the sealing substrate (66) on the tiled display panel (60) is then adjusted. This adjustment is performed so as to allow the black matrix (64) to be positioned correctly above the auxiliary wires (23) of the ribs (22) and to be positioned correctly above the boundaries (68) of the display panels (50). The UV-curing resin (62) is irradiated with UV beams to set the resin to fix the sealing substrate (66) to the tiled display panels (60), and a tiled display system (70) is then completed.

## Description

### Technical Field

The present invention relates to tiled display systems having a plurality of display panels or display units and relates to a method for manufacturing tiled display systems. The present invention particularly relates to a tiled display system having top emission-type organic EL (electroluminescent) display panels and relates to a method for manufacturing such a tiled display system.

### Background Art

Display systems including organic EL devices are expected to be used as the next-generation of flat panel displays and their commercialization is desired. In organic EL display systems, since the response rate of the organic EL devices is 1 µm/sec or less, duty driving by passive matrix addressing is possible. However, when the duty ratio is high when turning the display on and off, passive matrix addressing causes serious damage to the organic EL devices because a high current must be applied to the organic EL devices during a short period of time in order to obtain sufficient brightness. On the other hand, in active matrix addressing, a TFT (thin-film transistor) circuit is usually connected to a capacitor to maintain a voltage applied to the organic EL device. Therefore, active matrix addressing does not cause much damage to the organic EL devices since a constant voltage can be applied to the organic EL devices during one display frame, that is, a high current are not applied to the organic EL devices during a short period of time.

However, in display panels driven by active matrix addressing using TFTs, the TFTs occupy a certain area and the effective area of a pixel portion cannot be sufficiently obtained, thereby reducing the aperture ratio. A top emission-type device is effective in solving such a problem.

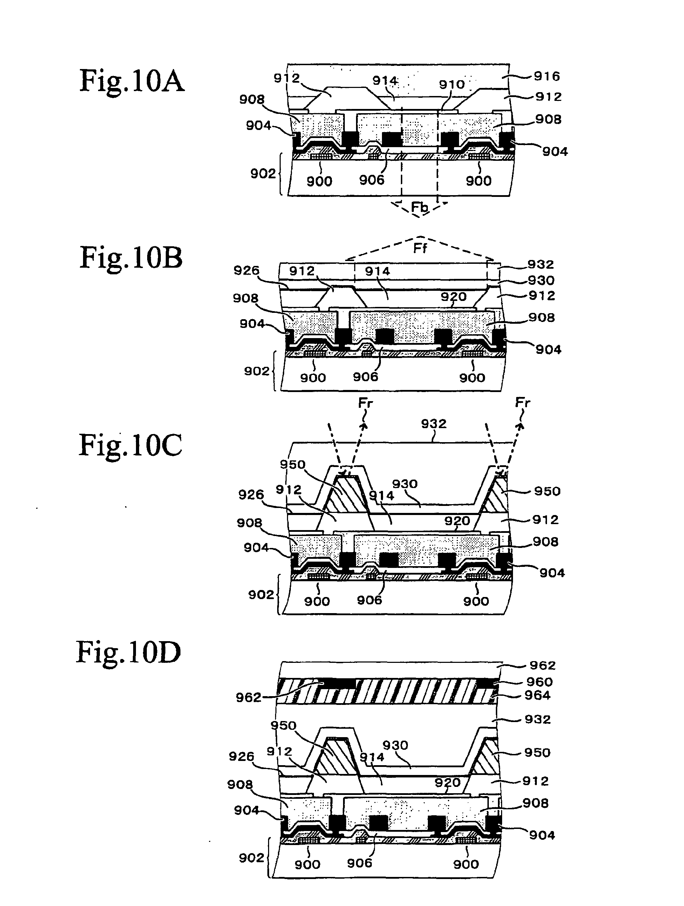

Among Figs. 10A to 10D, Fig. 10A shows a conventional organic EL device panel and Fig. 10B shows a top emission-type organic EL device panel. In Fig. 10A, electrode wires 904 are disposed on a substrate 902 with an interlayer insulating layer 906 located therebetween, the substrate 902 has TFTs 900 arranged in a matrix thereon, and the electrode wires 904 are connected to the TFTs 900. A planarizing insulating layer 908 and anodic electrodes 910 comprising a semi-transparent conductive material are disposed on the electrode wires 904 in that order. The anodic electrodes 910 are connected to the corresponding electrode wires 904.

Ribs 912 are disposed above the anodic electrodes 910, and organic EL layers 914 are disposed at portions located on the anodic electrodes 910 and surrounded by the ribs 912. The organic EL layers 914 include luminescent materials displaying, for example, red (R), green (G), and blue (B). The organic EL layers 914 each have an electron transport sublayer, a luminescent layer, and a hole transport layer (not shown). A cathodic electrode 916 comprising metal is disposed over the ribs 912 and the organic EL layers 914. Since the anodic electrodes 910 are semi-transparent and the cathodic electrode 916 is reflective, light output from organic EL layers 914 is emitted in the direction indicated by the arrow Fb.

In Fig. 10B showing the top emission-type organic EL device panel, the organic EL layers 914 and a cathodic electrode 926 comprising a semi-transparent conductive material are disposed on anodic electrodes 920 comprising metal in that order. The arrangement of the above components in Fig. 10B is the reverse of that in Fig. 10A. A protective layer 930 and a semi-transparent sheet 932 are disposed over ribs 912 and the cathodic electrode 926 in that order. Since the anodic electrodes 920 are reflective and the cathodic electrode 926 is semi-transparent, light output from organic EL layers 914 is emitted in the direction indicated by the arrow Ff. In the conventional type shown in Fig. 10A, the TFTs 900 are located at the light-emission side. However, in the top emission type shown in Fig. 10B, the TFTs 900 are not located at the light-emission side, thereby increasing the aperture ratio.

In the top emission-type organic EL display panel having a large aperture ratio, the cathodic electrode 926 is semi-transparent, that is, the cathodic electrode 926 is a semi-transparent conductive film, because emitted light is taken out of the cathodic electrode 926, namely, an upper electrode. Generally, since a semi-transparent electrode has a large sheet resistance, a voltage gradient arises in the display surface when the semi-transparent electrode is disposed over the principal surface of the display panel. Therefore, the brightness is decreased due to a decrease in voltage at the center of the display surface. As the display surface becomes larger, this phenomenon becomes more serious, thereby significantly degrading the display performance. In order to solve this problem, the following structure shown in Fig. 10C has been proposed: auxiliary wires 950 comprising metal are disposed on the ribs 912 and are connected to the cathodic electrode 926. In a display panel having this structure, non-uniform display due to the voltage gradient does not arise.

However, in the display panel having such wiring, since the reflection of external light by the auxiliary wires 950 is significant, the contrast of a displayed image is seriously deteriorated. In order to solve this problem, the following structure shown in Fig. 10D has been proposed: a black matrix 960 is disposed above the auxiliary wires 950 to prevent the contrast from being reduced. A sealing substrate 962 having the black matrix 960 is placed on the top of the structure shown in Fig. 10C with an UV-curing resin 964 located therebetween to form the structure shown in Fig. 10D. Since the black matrix 960 covers the auxiliary wires 950, the reflection of external light is suppressed and the contrast becomes high.

A tiling technique is known as a method for increasing the display size. In this technique, a plurality of flat display panel units are arranged in such a manner that they are tiled to form a large-screen display. In this large-screen display formed by the tiling technique, it is necessary to make the boundaries between adjacent display panels inconspicuous.

The present invention is based on the above findings. It is an object of the present invention to provide a tiled display system including organic EL display panels having improved high contrast by using a black matrix and to provide a method for manufacturing the tiled display system, wherein the tiled display system provides a high-quality display and has inconspicuous boundaries.

### Disclosure of Invention

In order to achieve the above object, the present invention provides a tiled display system having a large screen display formed by joining a plurality of display panels together. The tiled display system includes a sealing substrate disposed over the plurality of display panels, and a black matrix, for improving the contrast, disposed on the sealing substrate, wherein the black matrix is positioned above boundaries between the plurality of display panels.

In one of principal embodiments, the display panels each have a substrate, lower electrodes, organic EL layers, and an upper semi-transparent electrode disposed in that order; and light emitted from the organic EL layers is taken out of the upper semi-transparent electrode. In another embodiment, the display panels have a sealing layer for preventing the lower electrodes, the organic EL layers, and the upper semi-transparent electrode from being damaged. In another embodiment, the display panels have ribs surrounding each of the organic EL layers, the ribs each have a auxiliary wire electrically connected to the upper semi-transparent electrode, and the black matrix is positioned above the auxiliary wires. In another embodiment, the auxiliary wires at the boundaries between the display panels have a width that is approximately half of the width of the other auxiliary wires.

The present invention further provides a method for manufacturing a tiled display system, in which the method includes the step of cutting each display panel, having ribs, along the outside of the ribs close to end faces of the display panels used for joining the display panels together, among all the end faces of the display panels. In one of principal embodiments, each display panel is cut along the outside of the ribs with a laser. In another embodiment, the display panels have organic EL layers, and each display panel is cut with a laser before the organic EL layers are formed. The object described above and others, the characteristic features, and the advantages of the present invention will become further clearer by the embodiments described below with reference to drawings.

### Brief Description of the Drawings

Figs. 1A to 1C are principal illustrations showing a manufacturing process according to a first embodiment of the present invention.
Figs. 2A to 2C are principal illustrations showing the manufacturing process according to the first embodiment of the present invention.
Fig. 3 is an enlarged schematic perspective view of a part of Figs. 2A to 2C.
Figs. 4A to 4C are principal illustrations showing the manufacturing process according to the first embodiment of the present invention.
Figs. 5A to 5B are principal illustrations showing the manufacturing process according to the first embodiment of the present invention.
Figs. 6A to 6C are principal illustrations showing the manufacturing process according to the first embodiment of the present invention.
Fig. 7 is a schematic perspective view showing a situation in which a black matrix is placed on display panels after tiling.
Figs. 8A to 8B are principal illustrations showing a manufacturing process according to a second embodiment of the present invention.
Figs. 9A to 9D are principal illustrations showing the manufacturing process according to the second embodiment of the present invention.
Figs. 10A to 10D are principal sectional views showing display panels of the related art of the present invention.

### Best Mode for Carrying Out the Invention

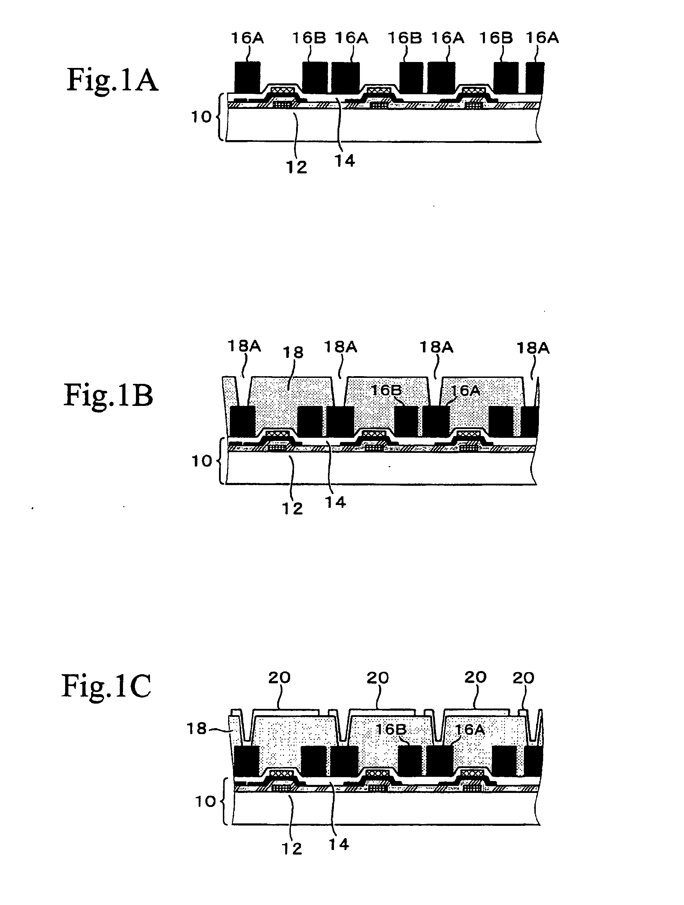

[First Embodiment] A first embodiment of the present invention will be described on detail. First of all, principal manufacturing steps are described. A tiled display system of this embodiment is an active matrix addressing type. A TFT substrate 10 shown in Fig. 1(A) is prepared first. The TFT substrate 10 has TFTs 12 arranged in a matrix corresponding to pixels. Various types of TFT substrates and manufacturing methods thereof are known and any one may be used. A gate electrode of each TFT 12 is connected to a scanning circuit (not shown).

A first interlayer insulating layer 14 is formed on the upper surface of the TFT substrate 10 so as to cover the TFTs 12. The first interlayer insulating layer 14 comprises, for example, a silicon-oxide-based material such as silicon oxide or PSG (phospho-silicate glass) containing silicon oxide and phosphorus. Wires 16A and 16B comprising aluminum or aluminum-copper alloy is formed on the first interlayer insulating layer 14 by patterning. The wires 16A and 16B function as driving signal lines and are connected to source electrodes or drain electrodes of the TFTs 12 through contact holes (not shown), disposed in the first interlayer insulating layer 14.

Next, as shown in Fig. 1(B), a second interlayer insulating layer 18 is formed so as to cover the wires 16A and 16B. The second interlayer insulating layer 18 preferably comprises a material that is capable of being readily planarized in order to cover the patterned wires 16A and 16B. This material preferably has a small water-absorbing property because an organic layer formed by deposition in a subsequent step is damaged by water and therefore high brightness cannot be achieved. In this embodiment, the second interlayer insulating layer 18 comprises polyimide. The second interlayer insulating layer 18 is formed over the upper surface of the TFT substrate 10, and contact holes 18A used for connection to the wires 16A are then formed in the second interlayer insulating layer 18.

As shown in FIG. 1(C), anodic electrodes (lower electrodes) 20 for organic EL layers are formed on the second interlayer insulating layer 18. In a top emission-type display panel of this embodiment, the anodic electrodes 20 preferably comprise a conductive material having a large work function and a high reflectance, such as chromium, iron, cobalt, nickel, copper, tantalum, tungsten, platinum, or gold. In this embodiment, the anodic electrodes 20 comprise chromium. Each anodic electrode 20 is patterned so as to correspond to each pixel and is connected to each wire 16A through the corresponding contact hole 18A disposed in the second interlayer insulating layer 18.

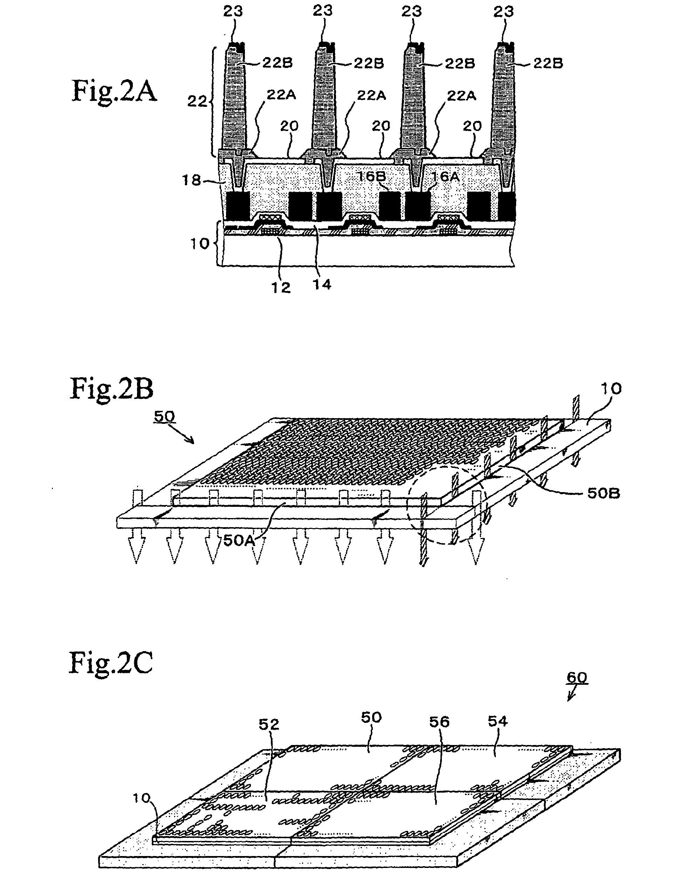

As shown in FIG. 2(A), ribs 22 are formed so as to surround pixels (organic EL layers). The ribs 22 have a height sufficiently larger than the thickness of the organic EL layers formed by deposition in a subsequent step. Therefore, the ribs 22 function as spacers for a mask when the organic EL layers are formed on the anodic electrodes 20 by patterning. In this embodiment, each rib 22 includes silicon oxide sublayer 22A and 22B, and the silicon oxide sublayer 22B has an aluminum layer functioning as an auxiliary wire 23 thereon. The silicon oxide sublayers 22A are formed in such a manner that the contact holes 18A are filled with the silicon oxide sublayers 22A and the silicon oxide sublayers 22A cover the peripheries of the contact holes 18A. The silicon oxide sublayers 22B are then each formed on the corresponding silicon oxide sublayers 22A. In this structure, the ribs 22 have a sufficient height. The silicon oxide sublayers 22A function as interlayer insulating layers and the silicon oxide sublayers 22B function as ribs.

The ribs 22 have tapered walls, as shown in Fig. 2(A), so as to maintain the coverage of an upper common electrode (cathodic electrode) above the ribs 22 having a considerably large height.

Fig. 2(B) is a schematic view showing a display panel 50 having the ribs 22 formed as above. As shown in FIG. 2(C), when the display panels 50-56 are joined together to form a tiled display system, the TFT substrate 10 of the display panel 50 must be cut along portions close to end faces 50A and 50B which are joined to corresponding end faces of the other display panels, among all the end faces of the display panel 50. In this embodiment, as shown in Fig. 2(B), the TFT substrate 10 is cut along the outside of the ribs 22 (or the end portions of auxiliary wires 23), as indicated by the arrows in Fig. 2(B), using a laser cutter. A laser cutter can perform highly precise cutting and does not require water as a coolant. Therefore, such a laser cutter is suitable for organic EL devices, which are damaged by water.

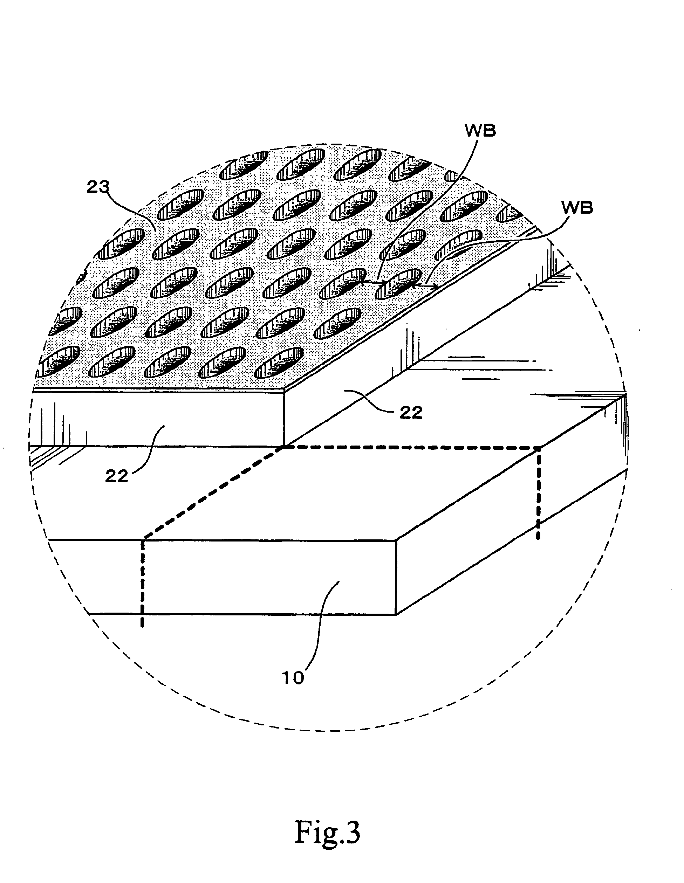

The laser cutter preferably uses a high-powered infrared laser such as a carbon dioxide laser. Laser beams output by the laser are applied onto a predetermined portion of the display panel substrate to rapidly heat the portion locally and the heated portion is then quenched by applying air, thereby causing the substrate to be cut by the stress generated by the above operation. Fig. 3 shows a corner consisting of the end faces 50A and 50B in an enlarged manner. The laser cutting must be finished before the organic EL layers are formed, because the laser cutting temporarily increases the temperature of the display panel 50 and organic EL layers described below are sensitive to heat, that is, they are damaged by heat.

In the display panel 50 including electrodes and organic EL layers, when the end faces 50A and 50B and end faces of the TFT substrate 10 are in the same plane, it is not necessary to cut the TFT substrate 10. Furthermore, another substrate for tiling may be prepared to arrange the display panels 50-56 thereon to join them together.

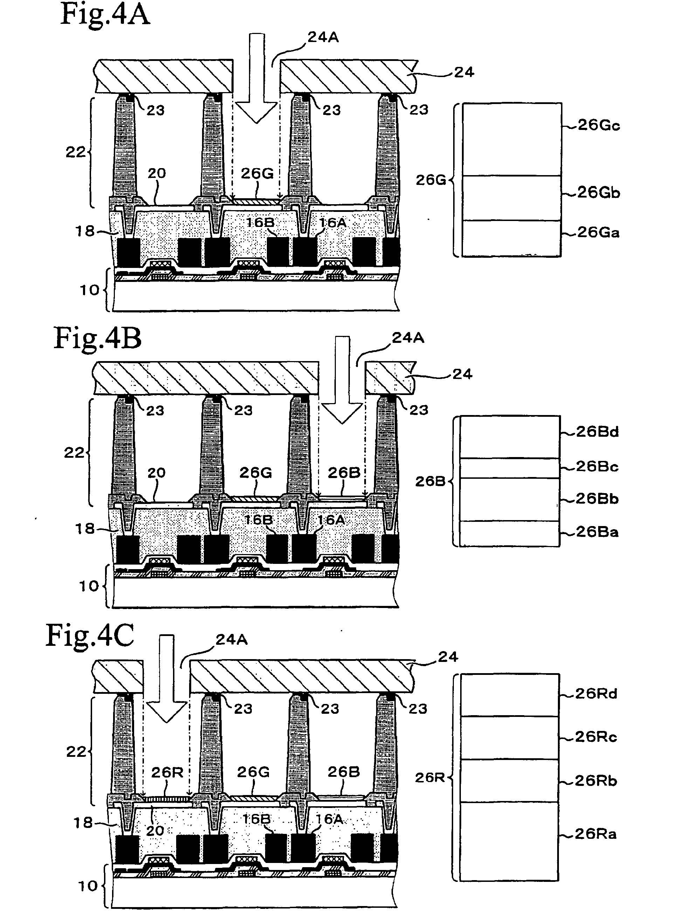

As shown in Fig. 4, organic EL layers displaying red (R), green (G), and blue (B) are formed by vapor deposition. In this embodiment, an organic EL layer displaying green, another organic EL layer displaying blue, and another organic EL layer displaying red are formed in that order. As shown in Fig. 4(A), a metal mask 24 having an opening 24A for forming R, G, and B pixels is prepared. Alignment is performed in such a manner that the opening 24A is positioned above the anodic electrode of a green pixel. A green organic EL layer 26G is formed on a green anodic electrode 20 by vapor deposition using resistance heating.
(1) 4,4',4"-tris(3-methylphenylphenylamino)triphenylamine(m-MTDATA) is deposited to 25 nm to form a hole injection layer 26Ga.
(2) 4,4'-bis(N-1-naphthyl-N-phenylamino)biphenyl(α-NPD) is deposited to 30 nm to form a hole transport layer 26Gb.
(3) Tris(8-quinolinolato)aluminum(III)(Alq3) is deposited to 50 nm to form a luminescent layer 26Gc. The above deposition of each layer is consequently performed in a deposition apparatus.

As shown in Fig. 4(B), alignment is performed in such a manner that the opening 24A is positioned above the anodic electrode of a blue pixel. A blue organic EL layer 26B is formed on a blue anodic electrode 20 by vapor deposition using resistance heating.
(1) 4,4',4"-tris(3-methylphenylphenylamino)triphenylamine(m-MTDATA) is deposited to 18 nm to form a hole injection layer 26Ba.
(2) 4,4'-bis(N-1-naphthyl-N-phenylamino)biphenyl(α-NPD) is deposited to 30 nm to form a hole transport layer 26Bb.
(3) 2,9-dimethyl-4,7-diphenyl-1,10-phenanthroline(bathocuproine) is deposited to 14 nm to form a luminescent layer 26Bc functioning as a hole-blocking layer.
(4) Tris (8-quinolinolato) aluminum(III) (Alq3) is deposited to 30 nm to form a luminescent layer 26Bd. The above deposition of each layer is consequently performed in a deposition apparatus.

As shown in Fig. 4(C), alignment is performed in such a manner that the opening 24A is positioned above the anodic electrode of a red pixel. A red organic EL layer 26R is formed on a red anodic electrode 20R by vapor deposition using resistance heating.
(1) 4,4',4"-tris(3-methylphenylphenylamino)triphenylamine(m-MTDATA) is deposited to 55 nm to form a hole injection layer 26Ra.
(2) 4,4'-bis(N-1-naphthyl-N-phenylamino)biphenyl(α-NPD) is deposited to 30 nm to form a hole transport layer 26Rb.
(3) 2,5-bis[4-(N-methoxyphenyl-N-phenylamino)styryl]benzene-1,4-dicarbonitrile(BSB-BCN) is deposited to 14 nm to form a luminescent layer 26Rc.
(4) Tris(8-qunolinolato)aluminum(III)(Alq3) is deposited to 30 nm to form an electron transport layer 26Rd. The above deposition of each layer is consequently performed in a deposition apparatus.

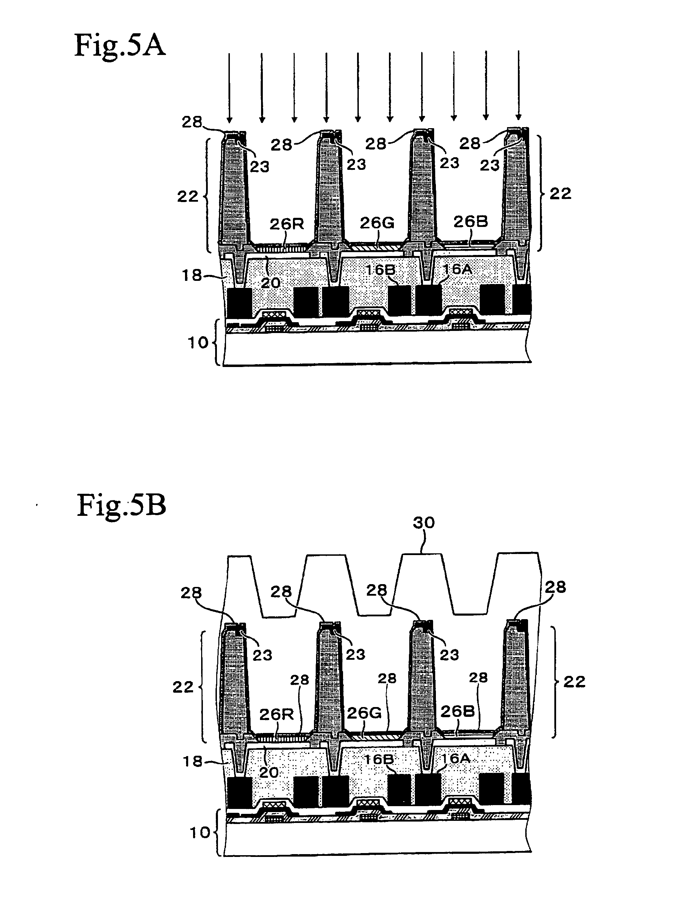

As shown in Fig. 5(A), a cathodic electrode (upper electrode) 28 is formed after the above organic EL layers 26 are formed. The cathodic electrode 28 functions as a common electrode of each pixel. The cathodic electrode 28 is formed using another mask in the above deposition apparatus in order to prevent the above organic EL layers 26 from being damaged. The cathodic electrode 28 preferably comprises a material having a small work function in order to efficiently inject electrons into the organic EL layers 26. Such a material includes, for example, magnesium and silver. In this embodiment, magnesium and silver are codeposited to 14 nm to form the cathodic electrode 28. The cathodic electrode 28 is electrically connected to the aluminum auxiliary wires 23 disposed on the ribs 22.

As shown in Fig. 5(B), a passivation layer 30 functioning as a protective layer is formed over the principal surface of the display panel 50. The passivation layer 30 is formed in the above deposition apparatus so as not to expose the cathodic electrode 28 to the atmosphere. For example, silicon nitride is deposited at room temperature by a CVD method to form the passivation layer 30. The organic EL layers 26 are seriously damaged at 100°C or more and therefore the emission brightness is decreased. In order to preventing layers from peeling off, it is preferable to form the organic EL layers 26 under conditions in which the stress in the layers is minimized. Therefore, the above deposition method is used.

A plurality of display panels prepared by the above procedure are joined together with an adhesive agent in such a manner that the tiles are set. For example, as shown in Fig. 2(C), the display panels 50-56 are joined together to form a tiled display panel 60. As described above, the display panels 50-56 are joined together at the corresponding end faces thereof, these end faces having been formed by the laser cutting. The red, green, and blue pixels in the display panels 50-56 are arranged in such a manner that the two-dimensional arrangement of the red, green, and blue pixels is uniform over the display panels 50-56.

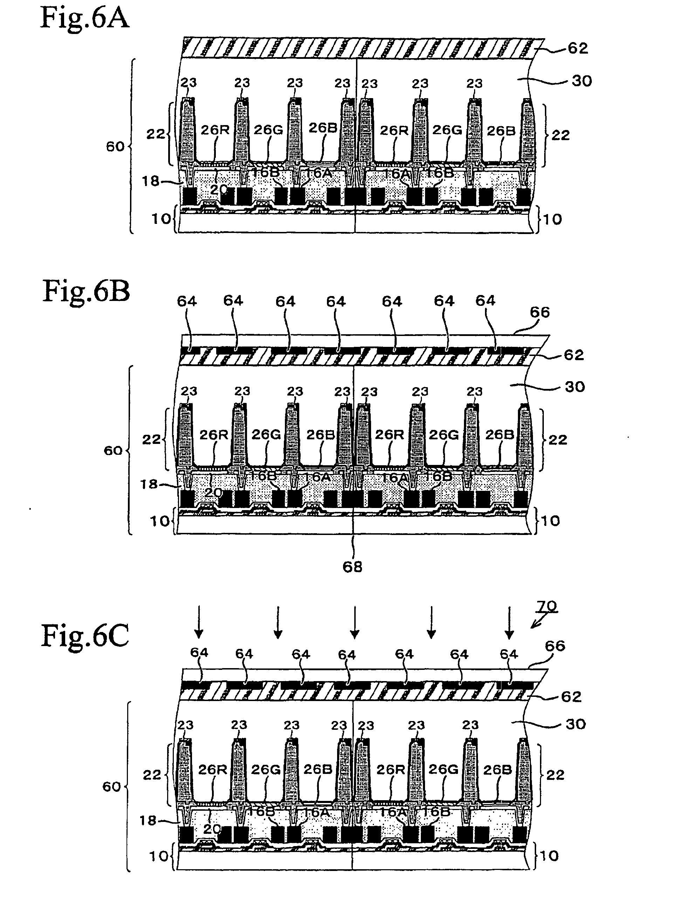

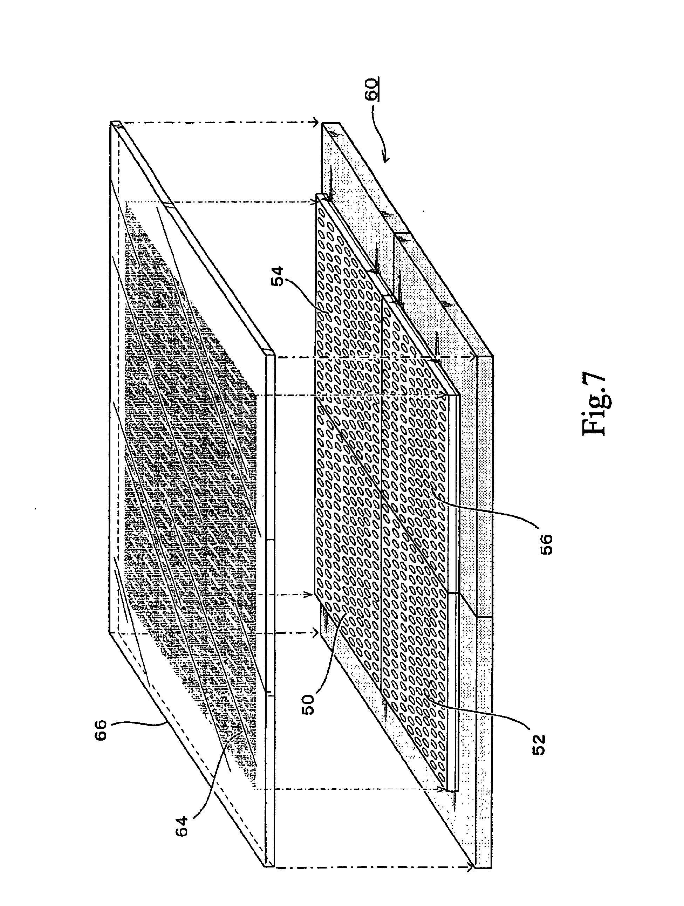

As shown in Fig. 6(A), a UV-curing resin 62 is applied onto the principal surface of the tiled display panel 60. This application is performed using a dispenser for discharging a resin, wherein the dispenser is a syringe type or a slit nozzle type. Other known methods such as a roll coating method and a screen printing method may be used. As shown in Fig. 6(B), a sealing substrate 66 having a black matrix 64 is prepared. The sealing substrate 66 is not used for each of the display panels 50-56 but is used for the tiled display panel 60. The sealing substrate 66 is joined to the principal surface of the tiled display panel 60 on which the UV-curing resin 62 is applied. In this step, it must be avoided that bubbles are between the UV-curing resin 62 and the sealing substrate 66. Fig. 7 shows a step of joining the sealing substrate 66 to the tiled display panel 60, wherein the UV-curing resin 62 is not shown.

As shown in Fig. 6(C), the black matrix 64 of the sealing substrate 66 is aligned with the pixels of the tiled display panel 60. When the UV-curing resin 62 is not set, the position of the sealing substrate 66 on the tiled display panel 60 can be changed by several hundred nm. The tiled display panel 60 has boundaries 68 between the display panels 50-56. As shown in Fig. 6(C), the adjustment of the position is performed in such a manner that the black matrix 64 are positioned correctly above the corresponding auxiliary wires 23 of the ribs 22 and are positioned correctly above the boundaries 68. The UV-curing resin 62 is irradiated with UV beams indicated by the arrows shown in Fig. 6(C) to cure the UV-curing resin 62 to fix the sealing substrate 66 to the tiled display panel 60, thus completing a tiled display system 70.

In the tiled display system 70, the reflection of external light caused by the auxiliary wires 23 is prevented by the black matrix 64. The boundaries 68 between the display panels 50-56 are covered by the black matrix 64. Therefore, a high-quality large-screen display having high contrast and inconspicuous boundaries can be obtained.

[Second Embodiment] A second embodiment of the present invention will now be described. In the above embodiment, as shown in Figs. 6(A) to 6(C), two of the ribs 22 are adjacent each other at each boundary 68 between the display panels 50-56. When the black matrix 64 entirely covers the auxiliary wires 23 of the ribs 22, as shown in Fig. 6(A) to 6(C), the organic EL layers 26 are partly covered by the black matrix 64, thereby reducing the brightness. In contrast, when the black matrix 64 does not entirely cover the organic EL layers 26 in order to obtain high brightness, the boundaries 68 are exposed under the black matrix 64, thereby allowing the boundaries 68 to appear on the screen.

In order to solve the above problem, the following method is proposed: each of the ribs 22 at the boundaries 68 should be cut in half. However, the cutting is not possible. That is, when laser cutting is performed, the object to be cut must absorb laser beams to rapidly increase the temperature thereof. However, each auxiliary wire 23 comprising metal is disposed on the corresponding rib 22 and metal has a large reflectance with respect to infrared laser beams. Therefore, the temperature of the ribs 22 cannot be increased by laser irradiation.

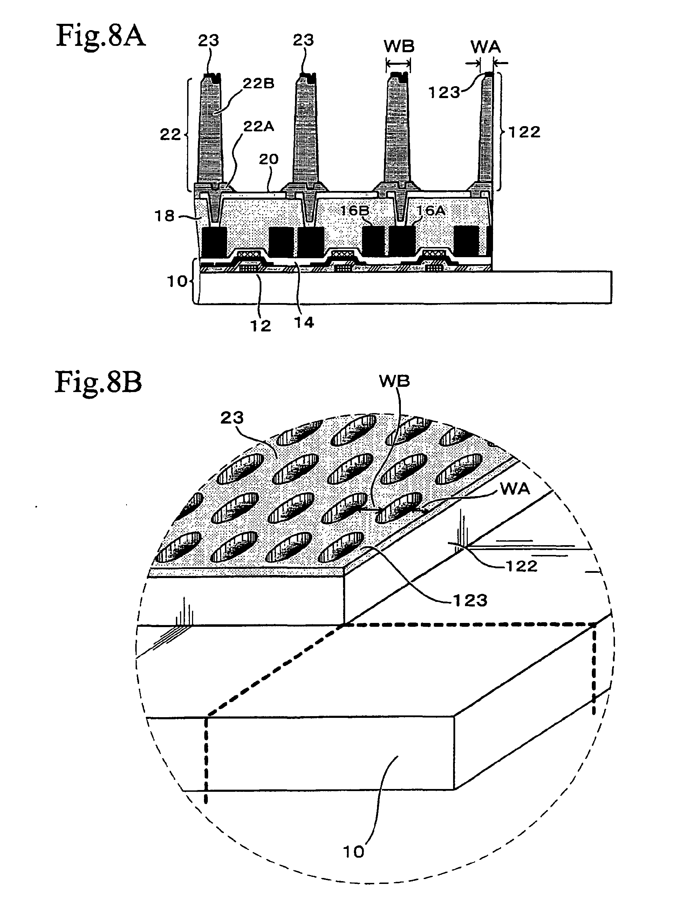

In this embodiment, as shown in Fig. 8(A), ribs 122 and auxiliary wires 123 are disposed at the end faces 50A and 50B of the display panel 50 which are each joined to an end face of the other display panels, wherein each auxiliary wire 123 is disposed on the corresponding rib 122. The width WA of the auxiliary wires 123 is smaller than the width WB of the auxiliary wires 23, for example, WA < (WB/2). The auxiliary wires 23 are each disposed on the corresponding rib 22, which are regularly arranged at a constant pitch. Since the auxiliary wires 123 have a small width, the reflection of laser beams by the auxiliary wires 123 is suppressed. Cutting is possible in such a manner that the auxiliary wires 123 has a small width. Fig. 8(B), which corresponds to Fig. 3, shows the display-panel end faces in this embodiment. The substrate is cut along the dotted lines, which extend along the edges of the ribs 122, with laser beams. After the cutting is finished, the organic EL layers 26, the cathodic electrode 28, and the passivation layer 30 are formed on the principal face in that order in the same manner as that in the first embodiment.

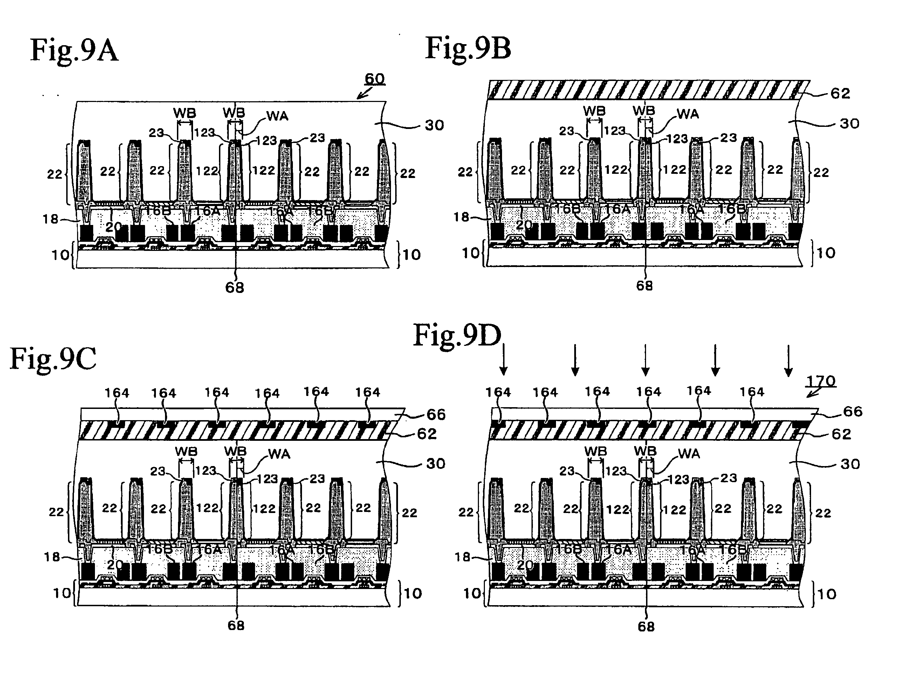

As shown in FIG. 2(C), the display panels 50-56 are joined together to form the tiled display panel 60. In this embodiment, as shown in Fig. 9(A), the ribs 122 having a width of approximately WB/2 are bonded to each other to form boundaries 68. The bonded ribs 122 have a width of WB. That is, the bonded ribs 122 have approximately the same width as that of the ribs 22. As shown in Fig. 9(B), the UV-curing resin 62 is applied onto the passivation layer 30. A black matrix 164 is provided on the sealing substrate 66 and the resulting sealing substrate 66 is placed onto the UV-curing resin 62 of the tiled display panel 60, as shown in Fig. 9(C). The position of the sealing substrate 66 is adjusted slightly so as to align the black matrix 164 with the pixels of the tiled display panel 60. Finally, as shown in Fig. 9(D), the UV-curing resin 62 is irradiated with UV beams indicated by the arrows to set the UV-curing resin 62, and the sealing substrate 66 is then fixed to the tiled display panel 60 to complete a tiled display system 170. The procedures shown in Figs. 9(B) to 9(D) are approximately the same as those in the first embodiment.

In the tiled display system 170 manufactured by the above procedures, the ribs 122 are joined each other at the junction of the display panels. The joined auxiliary wires located at the boundaries have approximately the same width of that of the other auxiliary wires. Therefore, boundaries do not appear on the screen and the high brightness can be obtained. In practice, in the laser cutting, the object to be cut preferably has a tab for cutting depending on the kind of material and the laser.

[Other Embodiments] In the present invention, various embodiments are possible and various modifications are also possible based on the above embodiments. For example, the following embodiments are also possible.
(1) The positions of the cathodic electrode and the anodic electrode may be reversed with respect to those in the above embodiments. The cathodic electrode may comprise metal, alloy, or an intermetallic compound having a small work function so as to efficiently inject electrons into the electron-transport layer. The anodic electrode may comprise metal, alloy, or an intermetallic compound having a large work function so as to efficiently inject holes into the hole-transport layer.
(2) Although the display panel 50 is a top emission type, the structure is not limited to the above embodiment. For example, the structures shown in Figs. 10C to 10D are possible. Generally, organic materials used for the organic EL layers are damaged by water and oxygen and therefore the light-emitting characteristics are decreased. Furthermore, the cathodic electrode and the anodic electrode are damaged by oxidation and therefore the hole-injection capability is significantly deteriorated. Thus, it is preferable to provide a sealing layer above the organic EL layer and the electrodes so as to prevent such components from making contact with the atmosphere. The following structure is also proposed: an organic resin layer is disposed between the protective layer 930 and the semi-transparent sheet 932 in Fig. 10C. The present invention is also applicable to such a structure.
(3) In the above embodiments, the present invention is applied to an organic EL display panel. However, the present invention is applicable to any tiled display systems such as plasma display panels. Furthermore, various driving methods may be used.

As described above, according to the present invention, the following advantages can be obtained.
(1) Since a black matrix is positioned above boundaries between a plurality of display panels, large-sized displays having inconspicuous boundaries on the screen can be obtained.
(2) Since ribs located at end faces of the display panels have a small width and are joined together, the boundaries of the display panels are covered by the black matrix, high-quality large-sized displays having no boundaries on the screen can be obtained.
(3) Since the substrate of each display panel is cut with a laser before organic EL layers are formed, precise cutting is possible and the deterioration of the organic EL layers does not arise.

## Claims

1. A tiled display system having a large screen display formed by joining a plurality of display panels together, comprising:
a sealing substrate disposed over the plurality of display panels; and
a black matrix, for improving the contrast, disposed on the sealing substrate,
wherein the black matrix is positioned above boundaries between the plurality of display panels.

2. The tiled display system according to Claim 1, wherein the display panels each have a substrate, lower electrodes, organic EL layers, and an upper semi-transparent electrode disposed in that order; and light emitted from the organic EL layers is taken out of the upper semi-transparent electrode.

3. The tiled display system according to Claim 2, wherein the display panels have a sealing layer for preventing the lower electrodes, the organic EL layers, and the upper semi-transparent electrode from being damaged.

4. The tiled display system according to Claim 2,
wherein the display panels have ribs surrounding each of the organic EL layers, the ribs each have a auxiliary wire electrically connected to the upper semi-transparent electrode, and the black matrix is positioned above the auxiliary wires.

5. The tiled display system according to Claim 4, wherein the auxiliary wires at the boundaries between the display panels have a width that is approximately half of the width of the other auxiliary wires.

6. A method for manufacturing a tiled display system having a large screen display formed by joining a plurality of display panels together, comprising the step of cutting each display panel, having ribs, along the outside of the ribs close to end faces of the display panels used for joining the display panels together, among all the end faces of the display panels.

7. The method for manufacturing a tiled display system according to Claim 6, wherein each display panel is cut along the outside of the ribs with a laser.

8. The method for manufacturing a tiled display system according to Claim 7, wherein the plurality of display panels have organic EL layers, and each display panel is cut with a laser before the organic EL layers are formed.
